(19) Europäisches Patentamt
European Patent Office
Office européen des brevets

(11) **EP 3 399 539 A1**

(12) **EUROPEAN PATENT APPLICATION**

(43) Date of publication:
**07.11.2018 Bulletin 2018/45**

(21) Application number: **17168949.0**

(22) Date of filing: **02.05.2017**

(51) Int Cl.:
*H01J 37/34* *(2006.01)*   *H01J 37/32* *(2006.01)*
*C23C 14/35* *(2006.01)*   *C23C 14/34* *(2006.01)*
*C23C 14/54* *(2006.01)*   *C23C 14/56* *(2006.01)*
*C23C 14/08* *(2006.01)*

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **Umicore
1000 Brussels (BE)**

(72) Inventor: **LIPPENS, Paul
2250 Olen (BE)**

(74) Representative: **Umicore RDI Patent Department
Watertorenstraat 33
2250 Olen (BE)**

(54) **PROCESS FOR DEPOSITING A LITHIUM COBALT OXIDE-BASED THIN FILM**

(57)    A process for depositing a lithium cobalt oxide-based thin film on a substrate in which the Li-stoichiometry ($Li_xCoO_2$) can be tuned within the limits $0.5 \leq x \leq 1.1$ using a standard stoichiometric $LiCoO_2$ target material combined with a second target material (Co or $Co_aO_b$) resp. Li or $Li_2O$ as the case may be either on a dual magnetron or on single magnetrons in adjacent coating chambers. In case of the usage of a dual magnetron, preferentially bipolar pulsed DC with a controlled duty cycle on each of the two cathodes is used in order to tune the stoichiometry of the coating. Alternatively, the $LiCoO_2$ target is powered with unipolar pulsed DC to a power $P_1$ and the Co or $Co_aO_b$ resp. Li or $Li_2O$ target is powered with DC or unipolar pulsed DC to a power $P_2$ in order to tune the stoichiometry. In case of the usage of single magnetrons in adjacent coating chambers, the power loads on the $LiCoO_2$ resp. Co or $Co_aO_b$ resp. Li or $Li_2O$ targets are tuned in order to achieved the required stoichiometry.

Fig.2

EP 3 399 539 A1

## Description

## Field of Invention

The present patent application falls in the domain of thin film batteries.

In particular, the present invention concerns a lithium cobalt oxide-based thin film battery and a process for making the cathode of said thin film battery.

More particularly, the process for making said cathode of the thin film battery is a sputtering-based process.

## Background of Invention

The present invention concerns a process for depositing a $LiCoO_2$ thin film on a substrate with a sputtering source. Such a process is implemented by the following well-known steps of:

- providing a substrate having a substrate surface;
- providing a first $LiCoO_2$ (or lithium cobalt oxide-based) target;
- mounting said first $LiCoO_2$ (or lithium cobalt oxide-based) target on a first sputtering cathode of the sputtering source so as to form a first magnetron of the sputtering source;
- placing the first sputtering cathode and the substrate into a vacuum chamber;
- supplying a $O_2$-containing sputtering gas (for instance an argon/$O_2$ mixture) to said vacuum chamber; and
- activating said sputtering source with an electric power supply so as to deposit on the substrate surface a thin film of lithium cobalt oxide as a result of a material deposited from the first sputtering cathode to the surface of the substrate.

This process is for instance known from US20150248997 which discloses an improved lithium cobalt oxide sputtering target to be used in a sputtering system.

US20150248997 focuses on modifications to the composition of the lithium cobalt oxide target to allow an adjustment or a fine-tuning of the resistance of the target. According to this document, the incorporation of a controlled amount of one or more conductive materials into the lithium cobalt oxide composition is described alone or in combination with altering the stoichiometric ratio of Li:Co to significantly reduce electrical resistivity and thereby enhance conductivity of the target. The result is a modified sputtering target capable of sputtering lithium-containing thin films that does not exhibit deterioration of the thin film properties by virtue of elevated levels of conductive material incorporated into the target.

In a first aspect of the target according to the relevant prior art; a sputtering target assembly for thin film lithium cobalt oxide deposition is provided. The assembly includes a backing plate which is bonded to a surface of a solidified target material. The solidified target material is derived from a composition comprising lithium cobalt oxide represented by the general formula $Li_xCoO_2$, where x has a value of 1.0 or greater. The composition is further defined by a chemical purity of 99% $Li_xCoO_2$ or higher. The solidified target material is characterized by a density which is 98% or higher of the theoretical density and by a particle size of up to 10 $\mu$m. The solidified target material further comprises one or more conductive materials incorporated into the composition at a predetermined amount to reduce resistance of the solidified target material and thereby enhance conductivity during sputtering of said solidified target material in comparison to a (lithium cobalt oxide) target that is characterized by the absence of incorporation of said one or more conductive materials.

In an alternative second embodiment of the target of US20150248997, the sputtering target assembly comprises a backing plate bonded to a surface of a solidified target material. The solidified target material is derived from a composition comprising lithium cobalt oxide represented by the general formula $Li_xCo_yO_2$. The composition is further defined by a predetermined stoichiometric ratio of Li:Co where x and y are both greater than 0. The solidified target material is characterized by a theoretical density of 98% or greater and a particle size of up to 10 $\mu$m. The $Li_xCo_yO_2$ composition further comprises one or more conductive materials incorporated therein at a predetermined amount to lower resistance of the solidified target material and thereby enhance conductivity during sputtering of said solidified target material in comparison to a (lithium cobalt oxide) target without incorporation of said one or more conductive materials.

In a third aspect, a third embodiment of the sputtering target assembly of US20150248997 is provided. This 3rd target assembly includes a backing plate bonded to a surface of a solidified target material. The solidified target material is derived from a composition comprising lithium cobalt oxide represented by the general formula $LiCoO_2$. The solidified target material is characterized by a theoretical density of 98% or greater and a particle size of up to 10 microns. In this 3rd embodiment, the $LiCoO_2$ presents a $Li_xCo_yO_2$ composition - characterized by the absence of an organic binder and defined by a predetermined stoichiometric ratio of Li:Co of less than about 1:1 as defined by x < y, to lower resistance of the solidified target material and thereby enhance conductivity during sputtering of said solidified target material to deposit thin film lithium cobalt oxide in comparison to a (lithium cobalt oxide) target represented by $LiCoO_2$ that is characterized by the absence of incorporation of said one or more conductive materials.

According to US20150248997, the thin film lithium cobalt oxide can be deposited by conventional sputtering target techniques, whereby the $LiCoO_2$ sputtering target assembly, defined as the $LiCoO_2$ sputtering target bonded to a backing plate, can be used to deposit the required thin film lithium cobalt oxide. With regards to sputtering targets to produce lithium cobalt oxide thin films, a *d.c. (direct current)* magnetron sputter source can be employed. The $Li_xCo_yO_2$ (or $LiCoO_2$) sputtering target forms a part of a cathode assembly that, together with an anode, is placed in an evacuated chamber filled with an inert gas, preferably argon. Magnets are disposed above the sputtering target (in case of a sputter down configuration), and the target backing plate is connected to a d.c. voltage source. A substrate support is positioned below the sputtering target within the chamber. In operation, a high voltage electrical field is applied across the cathode and the anode. The inert gas is ionized by collision with electrons ejected from the cathode. Positively charged gas ions are attracted to the cathode and, upon impingement with the target surface, these ions dislodge the target atoms. The dislodged target atoms traverse the evacuated enclosure and deposits as a $LiCoO_2$-based thin film on the desired substrate.

The sputtering target developed in US20150248997 has a decreased (electrical) resistivity allowing acceptable sputtering rates and which is compatible with a d.c. sputtering source.

Although the solution provided in US20150248997 allows the use of the more effective d.c. sputtering technology - and inherently allows the skilled person to tune the composition of the $LiCoO_2$-based sputtering target to optimize the resistivity of the latter - several drawbacks of this process are nevertheless highlighted:

1°) Firstly, the process of the prior art is constraining and therefore its implementation is difficult for $Li_xCoO_2$ with x = or > 1.0 [embodiment 1] and $Li_xCo_yO_2$ with x and y > 0 [embodiment 2] for which a certain amount of conductive material is to be provided in the target composition (-3.0 w.t. % of the total weight of the target) - this aspect makes the preparation of the target dependent of at least four parameters:

i) the stoichiometry of the $LiCoO_2$ fraction of the target;
ii) the purity of this $LiCoO_2$ fraction;
iii) the density of the target; and
iv) the amount of conductive material.

Provided that a (inter)dependency exists for at least the stoichiometry and the amount of conductive material of the target, the design of such a target of the prior art process becomes so complicated that the process itself does not allow an easy implementation of the thin film deposition on a substrate by the use of a sputtering process. Main reason is that a selection of a specific stoichiometry for the (final - i.e. resulting from the sputtering -) thin film product implies optimization of at least the parameters i) to iv).

2°) An identical reasoning presented in point 1°) can be argued for the 3rd embodiment of the target according to the prior art: if a target comprising a composition of $Li_xCo_yO_2$ wherein Li:Co is less than about 1:1 (as defined by x < y) is employed in the process of the prior art, the skilled person must ensure, in addition of optimizing parameters i) to iv) cited in point 1°), that no organic binder is present in the target material, which makes the production of such a target material very difficult.

3°) Even more critical: the process according to US20150248997 does not allow a control on the final $LiCoO_2$ composition of the thin film resulting from the sputtering.

Indeed, it is well known that, during the sputtering of a $LiCoO_2$ target with a d.c. sputtering source, there is an uncontrolled loss of lithium during its deposition from the target to the substrate's surface. This is for instance explained in US5171413.

The process of the prior art only focuses on the optimization of the target composition in view of achieving an optimal conductivity of the latter and therefore feasible operation of said target under d.c. conditions. When using this process, the skilled person has no possibility to control the $LiCoO_2$ stoichiometry of the final product (thin film) composition.

4°) Connected to drawback 3°), there is actually: i) a need to stick to the Li:Co ratio of 1.0 for a thin film battery based on $LiCoO_2$ chemistry, as confirmed for instance in Adv. Mat. Lett. 2013 4(8), 615 - 620; and ii) a (promising) tendency to explore thin film batteries wherein the thin film coating is composed of a $Li_xCo_{1.00}O_{2.00}$ with x > 1.00 and therefore a need to (better) control the stoichiometry of the lithium cobalt oxide-based thin film resulting from a sputtering process. It is for instance well-known that the highest reversible capacity of $LiCoO_2$ is achieved for a Li:Co ratio of 1.10 [see for instance: Lithium-Ion Batteries: Fundamentals and Applications - Volume 4 of Electrochemical Energy Storage and Conversion, Yuping Wu, CRC Press, 2015 - ISBN 1498760066, 9781498760065]. For the reasons provided in point 3°) above; the process of the prior art does not allow the skilled person to achieve such a flexibility. Other reasons of this statement are provided below:

5°) Finally, connected to point i) of drawback 4°); stoichiometric ceramic $LiCoO_2$ targets such as the one disclosed in US20150248997, which are known to have a relatively low electrical conductivity, are typically sputtered with unipolar pulsed d.c. using low duty cycles (to suppress arcing) in an oxygen-rich sputter atmosphere (to replenish lost oxygen in the sputter transfer/deposition process). In this framework, only low power load is possible and - together with the low duty cycle - this results in low dynamic (or static, depending on the coater configuration) deposition rates.

In relation with point 4°) above, a process for adjusting the Li:Co molar ratio of the thin film coating of lithium cobalt oxide produced by a sputtering method is known from US5171413. This document specifically mentions that a less than stoichiometric deposit of a $LiCoO_2$ layer is a well-known pitfall of sputtering techniques with a stoichiometric $LiCoO_2$ target (wherein Li:Co ratio = 1.0): the composition of the resultant layer is $Li_xCoO_2$ wherein x is less than 1.0. This observation is moreover confirmed in Adv. Mat. Lett. 2013 4(8), 615 - 620.

According to US5171413, the observed deficiency of lithium in the thin film layer can be ameliorated by a processing step which may be performed either during deposition of the layer or after deposition of the layer and before deposition of a second electron conductor layer (if a second electron conductor layer is to be deposited). This processing step involves, in one embodiment, striking a plasma between the as-coated substrate and a target assisted by the application of a biasing *d.c.* voltage to the substrate. In such a framework, the introduction of Li ions in the Li deficient coating layer on the substrate is ensured by a transfer of Li ions from a Li-enriched plasma to the thin film during deposition.

In this framework, the number of lithium ions added to the Li-deficient $Li_xCoO_2$ layer does not exceed the number of lithium ions needed to cure the lithium-deficiency therein; all surplus lithium ions are expelled into the plasma.

Although the adjustment provided by US5171413 allows compensation of Li loss during sputtering; the control of the stoichiometry of the thin film resulting from the sputtering of a stoichiometrically balanced $LiCoO_2$ target is only possible for a Li:Co ratio of 1.0 in the final thin film coating; and the technique provided in the prior art does not allow the skilled person to explore Li:Co ratios > 1.0, mainly due to the inherent "limitation" of the plasma assisted process that ensures that the number of lithium ions added to the Li-deficient $Li_xCoO_2$ layer does not exceed the number of lithium ions needed to cure the lithium-deficiency therein.

Another document [Electrochemical Behavior and Li Diffusion Study of LiCoO2 Thin Film Electrodes Prepared by PLD by Xia, H.; Meng, Shirley Y.; Lu, Li; Ceder, Gerbrand (Ceder et al.)- published in DSpace@MIT : http://hdl.handle.net/1721.1/35827]teaches that $LiCoO_2$ thin films are grown on Si substrates at a substrate temperature of 600 °C in an oxygen atmosphere of 100 mTorr for 40 min by PLD (*Pulsed Laser Deposition*) with a non-stoichiometric $LiCoO_2$ target with 15% excess $Li_2O$ to compensate for lithium loss during the deposition. The PLD technology described in this document employs a dual target composed of non-stoichiometric $LiCoO_2$ and $Li_2O$. Such a chemically modified (blended) target composition is for instance known from the following article: Journal of Applied Physics 115(15):154906-154906-5 - April 2014.

In the article of Ceder *et al.*, a thin film coating of $Li_{1.0}Co_{1.0}O_{2.0}$ is deposited on a $Si/SiO_2$ substrate and the Li ions diffusivity is explored in the $LiCoO_2$ film at different Li concentrations : $0.15 < x < 0.75$ within $Li_xCoO_2$ during charge/discharge of - i.e. lithium insertion/extraction in - $Li_{1.0}Co_{1.0}O_{2.0}$- It must be understood here that the article of Ceder *et al.* focuses on the study of the Li diffusivity during lithium extraction of $LiCoO_2$. The $LiCoO_2$ is ensured to be stoichiometrically balanced [Li:Co ratio = 1.0] by the use of a PLD sputtering technique in presence of a coupled $LiCoO_2$ - $Li_2O$ (therefore non-stoichiometric) composite target. In such a context, the terms *"non-stoichiometric $LiCoO_2$ target with 15% excess Li2O to compensate for lithium loss during the deposition"* must be understood as: a target having a global over-stoichiometric Li:Co ratio, said over-stoichiometric feature being ensured by the presence of a Li excess in the target composition.

The process disclosed in Ceder *et al.* is a conventional process that allows to compensate Li loss during PLD sputtering so as to provide a stoichiometric $LiCoO_2$ thin film coating after sputtering.

In view of the current prior art landscape, there is actually a need for an alternative to the prior art solutions in order to resolve the above-mentioned problems, and in particular, to provide a sputtering process that allows the thin film resulting from said process to be stoichiometrically controlled so as to provide a final thin film on the substrate's surface that has a desired stoichiometry. Such a process would allow to provide to the skilled person the required flexibility to explore compositions beyond the currently targeted stoichiometric $LiCoO_2$ composition, in particular for Li:Co ratios > 1.0. By analogy, the present process according to the invention allows exploring stoichiometry wherein Li:Co ratios are inferior to 1.0. Indeed, the interest in going to a Li-deficient stoichiometry in a thin film cathode material for use in a thin film battery is obvious in view of the following known expectations:

- first expectation: when de-intercalating Li from a stoichiometric $LiCoO_2$ coating in a thin film battery system, large stresses associated with a large volume change happen in the first cycle.
  For a coating wherein $Li_xCoO_2$ with x < 1.0, at first de-intercalation, such (compressive) stresses are sensitively reduced. Upon first intercalation then, a small tensile stress is developed. In other words: for the as-deposited coatings one "*freezes in*" a zero stress situation (certainly after annealing) and the resulting absolute value of stress upon de-intercalation/intercalation will be smaller for $Li_xCoO_2$ with x < 1.0 and therefore better cyclability of the cathode material.

- second expectation: a $Li_xCoO_2$ coating with x < 1.0 presents a higher electronic and ionic conductivity - i.e. a metal-like conductivity behavior).

## Summary of Invention

The present invention aims to solve or reduce the above mentioned and other problems by providing a process as above mentioned in the preamble characterized in that it comprises the further steps of:

- providing as the sputtering source a dual magnetron sputtering source comprising a bipolar pulsed direct current (BP-DC) power supply connected to the first sputtering cathode and to a second sputtering cathode
- providing a second Co-based or Li-based material target;
- mounting said second Co-based or Li-based target on said second sputtering cathode, so as to form a second magnetron of the dual magnetron sputtering source;
- placing said second sputtering cathode in the vacuum chamber;

**and in that** the step of activating said sputtering source consists in activating the bipolar pulsed direct current (BP-DC) power supply for alternatively applying on each of the first and second magnetrons a nominal electrical power $P_{nom}$ of a predetermined value so as to alternatively deposit on the substrate surface the lithium cobalt oxide from the first sputtering cathode and the lithium or the cobalt material from the second sputtering cathode, and further characterized in that duty cycles ($d_1$, $d_2$) during which the nominal electrical power $P_{nom}$ is respectively applied on each of the two cathodes (1,2) are controlled so as to reach a thin film composition presenting a controlled molar ratio Li:Co.

The process according to the present invention has the following advantages:

- firstly, using a BP-DC power supply allows any (asymmetric or symmetric) loading of the sputter power in terms of duration on each of the two cathodes (magnetrons): in the present invention, the bipolar pulsed power supply is activated so as to induce a power $P_{nom}$ [nominal power] on the dual magnetrons.

Due to the control of the cycles $d_1$ and $d_2$ (or during periods $t_1$ and $t_2$) during which the $P_{nom}$ is alternatively applied on each cathode, a different deposition rate from each of the two cathodes of the twin pair is obtained. Considering that the difference in deposition rate also results from the usage of different target materials for the first and second cathodes of the sputtering source, the duration of the first and second parts $t_1$ and $t_2$ of the period can be adapted accordingly.

A period (T) during which the signal ($P_{nom}$), of a frequency 1/T is applied, is divided over each of the two cathodes ($t_1 + t_2 = T$ with $t_1 \neq$ or $= t_2$) resulting in a nominal Work $W_{nom}$ on each of the cathodes: [$W_{nom1} = P_{nom} \times t_1$] $\neq$ or $=$ [$W_{nom2} = P_{nom} \times t_2$]; and hence, a tunable/adjustable deposition rate from each of the two cathodes.

In the framework of the present invention W is the work; $W_{nom}$ is therefore the nominal work and is equal to P (in watts) • t (in seconds).

As each of the two cathodes have different target materials, the deposition rate will already be different even at a symmetrical period with $t_1 = t_2 = T/2$, but by tuning the asymmetry of the cycle such effect is strongly reinforced.

This results in a $LiCoO_2$-based thin film presenting a controlled molar ratio Li:Co.

This is demonstrated in the Examples below.

- secondly, the duty cycles of this power supply are variable in a window that is sufficient to allow any useful required Li:Co ratio of the thin film coating.

- thirdly, the process according to the present invention allows to considerably reduce the formation of arcs during the sputtering, allowing thin films with a higher quality (less pinholes) and a longer lifetime of the first lithium cobalt oxide target in use in the sputtering source. The reduction of arcing allows to work with higher power values which implies higher deposition rates and, as a consequence, an enhancement of the coating line throughput.

More technical details relative to the operation of the process according to the invention are provided in the description below along with specific embodiments of the process.

Other details and advantages of the present invention will become apparent from the description hereunder of preferred and non-limitative embodiments of the process according to the invention:

## Embodiment 1

In a first embodiment of the process according to the invention, the duty cycles (or durations $t_1$ and $t_2$ of the period T) are determined so as to have a deposition of a $Li_xCoyO_2$-based thin film wherein $0.50 \leq x/y :5 1.10$.

If the second magnetron comprises the Co-based second target, the duty cycles are determined so as to have a deposition of a $Li_xCoO_2$-based thin film wherein $0.50 \leq x < 1.00$, in particular $0.60 \leq x \leq 0.80$.

If the second magnetron comprises the Li-based second target, the duty cycles are determined so as to have a deposition of a $Li_xCoO_2$-based thin film wherein $1.00 \leq x \leq 1.10$.

**Embodiment 2**

In a second embodiment of the process according to the present invention, when the second magnetron comprises the Li-based second target, the duty cycles are determined so as to have a deposition of a $Li_xCoO_2$-based thin film wherein $1.00 \leq x \leq 1.10$, in particular $x = 1.00$.

**Embodiment 3**

In a third embodiment of the process according to the present invention, when the second magnetron comprises the Co-based second target, the duty cycles are determined so as to have a deposition of a $Li_xCo_yO_2$-based thin film wherein $0.50 < x/y \leq 1.00$, preferably $0.60 \leq x/y \leq 0.80$, even more preferably $0.50 < x \leq 1.00$.

**Embodiment 4**

In a fourth embodiment, the process according to the invention comprises an additional step of providing as the second Co-based target a $Co_aO_b$-based target with $0 < a \leq 3$ and $0 < b \leq 4$, wherein a ratio a/b is preferably equal to 3/4.

**Embodiment 5**

In a fifth embodiment, the process according to the invention comprises an additional step of providing as the second Li-based target a $Li_2O$-based target.

**Embodiment 6**

In a sixth embodiment, the step of activating said bipolar pulsed DC power supply is performed so as to alternatively apply the nominal power $P_{nom}$ at a frequency comprised between 0.5 kHz to 500 kHz.

**Embodiment 7**

In a seventh embodiment of the process according to the invention, the lithium cobalt oxide thin film is annealed so as to present a rhombohedral/hexagonal crystallographic structure, preferably free of spinel (cubic structure).

**Embodiment 8**

In an 8th embodiment of the process according to the invention, the step of providing a first $LiCoO_2$ target consists in providing a target with a composition: $Li_{y'}Co_zO_2$ wherein $y' = z = 1.00$.

Each of the individual process **Embodiments 1 to 8** described here-above may be combined with one or more of the process embodiments described before it.

In the scope of the present invention, an oxy-gen-containing (or $O_2$-rich) sputtering atmosphere comprises at least 10 vol.% (preferably 25 vol.%) of $O_2$ (vol% in relation to the total flow), the rest of the sputtering gas comprising Ar.

More details of the present invention are provided in the description below.

**Brief Description of the Figures**

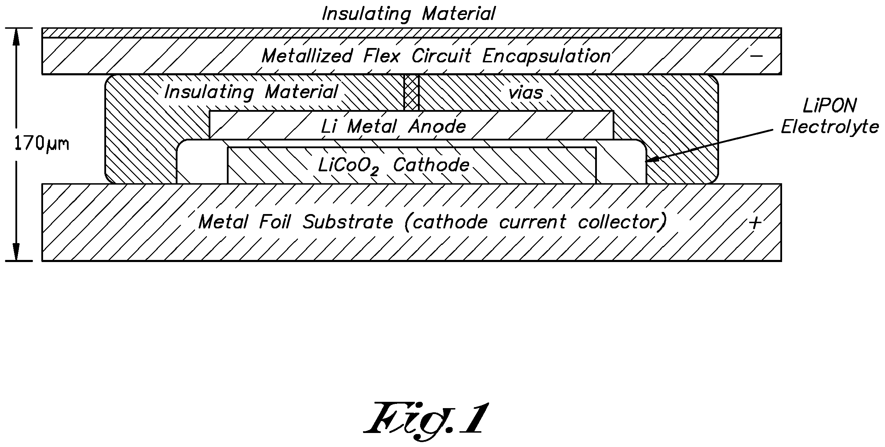

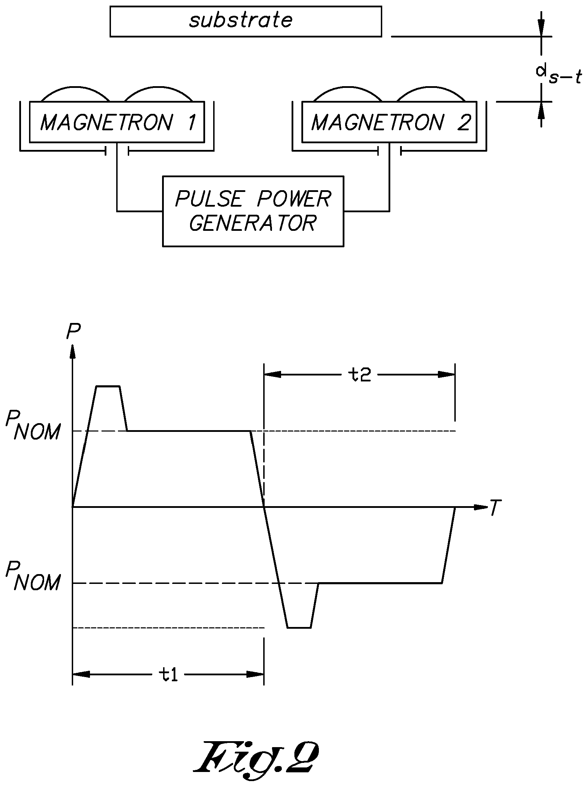

In order to explain the invention; a non-limiting example of a specific embodiment of the process according to the invention and its implementation is given below, with reference to the figures 1 and 2:

- figure 1 shows a thin film battery having a lithium cobalt oxide cathode material; and
- figure 2 depicts a sputtering source used in the process according to the present invention.

**Detailed Description**

The present invention concerns the manufacturing of a thin film battery [TFB] device comprising a $LiCoO_2$ cathode which is deposited as a coating on the metal foil or other substrate of a TFB as the result of magnetron sputtering (see figure 1).

The present invention covers a sputtering process for manufacturing a $LiCoO_2$ cathode material on a substrate.

The process according to the present invention can be implemented to produce: 1) a Li-over-stoichiometric cathode material; 2) a stoichiometric cathode material; or 3) a Li-under-stoichiometric cathode material.

1) Manufacturing of a Li- over-stoichiometric cathode material: $Li_xCoO_2$ wherein $x > 1.0$

In the framework of manufacturing a Li-over-stoichiometric cathode material, the process comprises the following steps:

- providing a substrate of the thin film battery having a substrate surface;
- providing a first Li-based target;
- providing a second $Li_{y'}Co_zO_2$ target, wherein $y' = z = 1.0$;
- providing a dual magnetron sputtering source comprising a bipolar pulsed direct current (BP-DC) power supply connected to a first sputtering cathode and to a second sputtering cathode;
- mounting said first Li-based target on said first sputtering cathode, so as to form a first magnetron;
- mounting said second $Li_{y'}Co_zO_2$ (with $y' = z = 1.0$) target on said second sputtering cathode, so as to form a second magnetron;
- placing said cathodes of the dual magnetron and said substrate in a vacuum chamber;
- supplying an oxygen ($O_2$)-rich sputtering gas (for instance, a mixture of $Ar/O_2$) to said vacuum chamber;
- activating said bipolar pulsed power (BP-DC) supply in a power control mode for inducing a predetermined power magnitude ($P_{nom}$ or nominal power) applied on each of the first and second magnetrons with controlled duty cycles (with $t_1 + t_2$ = period T = 1/f wherein f is a frequency and with $t_1 \neq$ or = $t_2$), so as to create plasma discharges in the vacuum chamber inducing deposition of a thin film of lithium cobalt oxide on the surface of said substrate; therefore
- controlling [$P_{nom}$ x $t_1$] and [$P_{nom}$ x $t_2$] applied on each of the first and second magnetrons so as to have deposition of a lithium cobalt oxide thin film comprising $Li_xCoO_2$ wherein x > 1.0.

2) Manufacturing of a stoichiometric cathode material: $Li_xCoO_2$ wherein x = 1.0

In the framework of manufacturing a stoichiometric cathode material, the process comprises the following steps:

- providing a substrate of the thin film battery having a substrate surface;
- providing a first Li-based target;
- providing a second $Li_{y'}Co_zO_2$ target, wherein y' = z = 1.0;
- providing a dual magnetron sputtering source comprising a bipolar pulsed direct current (BP-DC) power supply connected to a first sputtering cathode and to a second sputtering cathode;
- mounting said first Li-based target on said first sputtering cathode, so as to form a first magnetron;
- mounting said second $Li_{y'}Co_zO_2$ (with y' = z = 1.0) target on said second sputtering cathode, so as to form a second magnetron;
- placing said cathodes of the dual magnetron and said substrate in a vacuum chamber;
- supplying an oxygen ($O_2$)-rich sputtering gas (for instance, a mixture of $Ar/O_2$) to said vacuum chamber;
- activating said bipolar pulsed power (BP-DC) supply in power mode for inducing a predetermined power magnitude ($P_{nom}$ or nominal power) applied on each of the first and second magnetrons with controlled duty cycles ($t_1 \neq$ or = $t_2$ with $t_1+t_2$ = T, the period), so as to create plasma discharges in the vacuum chamber inducing deposition of a thin film of lithium cobalt oxide on the surface of said substrate; therefore
- controlling the durations $t_1$ and $t_2$ applied on each of the first and second magnetrons so as to have deposition of a lithium cobalt oxide thin film comprising $Li_xCoO_2$ wherein x = 1.0.

Providing extra lithium in the thin film (coming from the powering of the Li-based target during $t_1$) compensates for the Li-loss which happens during sputtering of a stoichiometric $LiCoO_2$ target.

3) Manufacturing of a Li-under-stoichiometric cathode material: $Li_xCoO_2$ wherein x < 1.0, preferably wherein $0.6 \leq x \leq 0.8$.

In the framework of manufacturing an under-stoichiometric cathode material, the process comprises the following steps:

- providing a substrate of the thin film battery having a substrate surface;
- providing a first Co-based target;
- providing a second $Li_{y'}Co_zO_2$ target, wherein y' = z = 1.0;
- providing a dual magnetron sputtering source comprising a bipolar pulsed direct current (BP-DC) power supply connected to a first sputtering cathode and to a second sputtering cathode;
- mounting said first Co-based target on said first sputtering cathode, so as to form a first magnetron;
- mounting said second $Li_{y'}Co_zO_2$ (with y' = z = 1.0) target on said second sputtering cathode, so as to form a second magnetron;
- placing said cathodes of the dual magnetron and said substrate in a vacuum chamber;
- supplying an oxygen ($O_2$)-rich sputtering gas (for instance, a mixture of $Ar/O_2$) to said vacuum chamber;
- activating said bipolar pulsed power (BP-DC) supply in power mode for inducing a predetermined power magnitude ($P_{nom}$ or nominal power) applied on each of the first and second magnetrons with controlled duty cycles ($t_1 \neq$ or = $t_2$, with $t_1+t_2$ = period T of the discharge), so as to create plasma discharges in the vacuum chamber inducing deposition of a thin film of lithium cobalt oxide on the surface of said substrate; thereby
- controlling the durations $t_1$ and $t_2$ during which each of the two magnetrons is cathode applied on each of the first and second magnetrons so as to have deposition of a lithium cobalt oxide thin film comprising $Li_xCoO_2$ wherein x < 1.0, preferably $0.6 \leq x \leq 0.8$.

In the processes 1) to 3) according to the invention, the bipolar pulsed power (BP-DC) supply is activated so as to induce a power on the dual magnetrons of a predetermined magnitude ($P_{nom}$ or nominal power). An asymmetric or a symmetric loading using a BP-DC power supply (as a sputtering source) allows an alternative sputter/discharge at a predetermined power $P_{nom}$ of the first/second magnetron.

The durations $t_1$ and $t_2$ of the discharge on each of the two magnetrons are variable in a window that is sufficient to allow any useful required Li:Co ratio of the thin film coating

Figure 2 depicts a schematic representation of the sputtering source according to the present invention.

The present invention is inclusive of the use of a dual magnetron sputtering source comprising a bipolar pulsed direct current (BP-DC) power supply.

Such a sputtering source is described in the Figure 2.

Figure 2 provides a pulse power generator connected to a first magnetron 1 and a second magnetron 2 disposed at a distance $d_{s-t}$ from the substrate. The combination of the pulse power generator with the magnetrons defines the sputtering system destined to be introduced in the vacuum chamber together with the substrate. The vacuum chamber is then filled with the sputtering gas before the sputtering system operates.

In Figure 2, durations $t_1$ and $t_2$ are related to duty cycles $d_1$ and $d_2$ which are given in percent:

$$d_1 = t_1/T \times 100 \% \text{ and } d_2 = t_2/T \times 100\%$$

The implementation of the sputtering source is defined by the following parameters:

- the $d_{s-t}$ which is the distance between the substrate surface and the targets 1 - 2 of magnetrons 1 - 2. Said distance is of generally between 0.03 and 0.12 m;
- $P_{nom}$ of the power generator;
- $d_1$ (= $t_1/T * 100\%$) and $d_2$ (= $t_2/T * 100\%$).

Duty cycles $d_1$ and $d_2$ on the first cathode and/or on the second cathode varies from 5 to 95% of the period T.

The frequency is chosen in order to suppress arcing as much as possible (the higher the frequency, the lower the arcing tendency), but lower frequencies yield higher deposition rates (less transitions to low or no power).

For a given frequency, the duty cycles $d_1$ and $d_2$, or by equivalency: the durations $t_1$ and $t_2$, on each of the two cathodes are chosen in function of the stoichiometry of the thin film which one wants to achieve.

Referring to figure 2, the duty cycle of magnetron 1 is $d_1$; whereas the duty cycle of magnetron 2 is $d_2$. T is the period. So that, for instance, a duty cycle of 5% has a duration d of 5% of T.

Implementation of the process according to the present invention implies, for instance, mounting a first Li- or Co-based target on a first cathode so as to form a first magnetron (magnetron 1).

Then a second $Li_{1.00}Co_{1.00}O_{2.00}$ target is mounted on a second cathode so as to form a second magnetron (magnetron 2).

Said first and second magnetrons 1, 2 are connected to a bipolar pulsed DC power generator arranged to apply on each magnetron a loading power $P_{nom}$.

During operation, a loading power $P_{nom}$ is applied on the first magnetron 1 so as to allow discharge of the first magnetron 1 for a first predetermined duty cycle $d_1$. During discharge of the first magnetron 1, the second magnetron 2 operates as anode.

After sputtering of the first magnetron 1 is effected (during $t_1$ time-window); the second magnetron is powered at $P_{nom}$ for a window-period governed by a second predetermined duty cycle $d_2$ (duration $t_2$).

During $t_2$, the fist magnetron 1 is operating as the anode.

The cycle is repeated (frequency f) until achievement of a thin film coating of a desired thickness on the substrate.

By modulating $d_1$ and $d_2$ values; a coating with the desired stoichiometry is achieved.

The implementation of the sputtering source is defined by the following parameters:

- the $d_{s-t}$ which is the distance between the substrate surface and the targets 1 - 2 of magnetrons 1 - 2;
- $P_{nom}$ of the pulse power generator;
- $d_1$ and $d_2$.

Duty cycle on the first cathode and/or on the second cathode varies from 5 to 95% of the period T ($d_1 + d_2 = 100\%$).

Referring to figure 2, the duty cycle of magnetron 1 is $d_1$; whereas the duty cycle of magnetron 2 is $d_2$. T is the period at which each cathode is sputtering/discharging. So that, for instance, a duty cycle of 5% has a duration d of 5% of T.

In the specific embodiment disclosed in figure 2, the first magnetron 1 is sputtered at $P_{nom}$ during $t_1$ resulting in a first duty cycle $d_1$ at a frequency f (= 1/T) whereas the second magnetron 2 is sputtered at $P_{nom}$ during $t_2$ resulting in a second duty cycle $d_2$, with $t_1 + t_2 = T$ and $d_1 + d_2 = 100\%$.

By modifying the duty cycle accordingly, the skilled person can obtain any of the (under-/over-) stoichiometric lithium cobalt oxide as specified in the manufacturing processes 1); 2) or 3) here-above.

**Example 1: Manufacturing of an under-stoichiometric cathode thin film - Li:Co molar ratio between 0.60 - 0.80.**

Employing a coater of the *Gen5.5* size (substrate size 1.30 m X 1.50 m = 1.95 $m^2$) with a dual planar cathode having a length of 1400 mm and a width of 272 mm.

The typical dynamic deposition rate (DDR) of a single planar cathode of stoichiometric $LiCoO_2$ under unipolar pulsed DC conditions (at a power of ~12 kW, or 3.15 W/$cm^2$) in a high $O_2$ content sputter process (25 vol.% $O_2$ the sputter gas, 60% duty cycle unipolar pulsed direct current [DC]) is measured at around 9.7 nm.m/min.

A typical DDR of pure cobalt used on a planar magnetron of the same size (using a strong magnet array constructed with NdFeB magnets) under DC conditions at the indicated power (12 kW) is some 13.5 nm.m/min in pure Ar, which typically drops to 8.1 nm.m/min for DC in a 25 vol.% $O_2$ sputter gas environment.

When a bipolar pulsed DC is used as a power source of said dual cathodes system with the same power (12 kW) and a 50%-50% (symmetric) distribution of duty cycles over the $LiCoO_2$ cathode w.r.t. the Co cathode, the DDR on the $LiCoO_2$ cathode drops to 8.08 nm.m/min, but the DDR on the Co cathode drops to 4.05 nm.m/min (50% of the DC case). In such a process, the resulting coating has a Li:Co at ratio of 0.58.

The Li:Co molar (or atomic) ratio is further increased by decreasing the duty cycle on the Co cathode. A 70-30% distribution of the duty cycle will lead to a Li:Co atomic ratio of 0.76 in the sputtered thin film $LiCoO_2$ cathode material. The ratio is 0.80 for a 75/25% distribution of duty cycles on respectively the $LiCoO_2$ and the Co cathodes. It is clear that within the limits imposed by the power supply hardware, the duty cycle distribution tuning results in any Li:Co desired molar ratios between 0.60 and 0.80.

**Example 2: Manufacturing cathode material - Li:Co molar ratio $\geq$ 1.00.**

Use of a coater of the *Gen5.5* size (substrate size 1.30 m X 1.50 m = 1.95 m$^2$) with a twin planar cathode system, each of the cathodes having a length of 1400 mm (each cathode having furthermore a width of 272 mm).

The dynamic deposition rate (at a power of 12 kW or 3.15 W/cm2) in a high $O_2$ content sputter process (25 vol% $O_2$ in the sputter gas, 60% duty cycle unipolar pulsed DC) for $LiCoO_2$ is measured as 9.7 nm.m/min.

DDR for lithium target is 0.614 nm.m/min in Ar 75 vol% and $O_2$ 25 vol% atmosphere (35 - 40% duty cycle on the Li target).

To avoid that the Li target melts, and as instantaneous power on the cathodes in each of the two cathode cycles is fixed (one cannot use an asymmetric power level on each of the two cathodes in the pair), power load on the $LiCoO_2$ cathode is reduced to 2 W/cm$^2$ to remain in a safe window.

Using a bipolar pulsed DC power load of 7.616 kW, the DDR of $LiCoO_2$ (60 % duty cycle) [with a duty cycle of the Li target being therefore 40%] at this power load is measured at 6.159 nm.m/min. Taking into account the physical densities of Li (0.534 g/cc) and $LiCoO_2$ (5.1 g/cc) and working with their molar masses of respectively 6.94 g/mol. (Li) and 97.87 g/mol. ($LiCoO_2$), a ratio between the DDR's of 0.0922 must be selected in order to get a $Li_xCoO_2$ coating with x equal to 1.10.

Considering a duty cycle of 65% on $LiCoO_2$ (first cathode/magnetron) and 35% on Li target (second cathode/magnetron), the DDR on $LiCoO_2$ is - at 2 W/cm$^2$ power load - 6.672 nm.m/min (65% duty cycle instead of 60%) and the DDR of Li is of: 0.614 nm.m/min (at the mentioned power load and 35% duty cycle).

The ratio of DDRs is then 0.0920, i.e. the expected value.

It is moreover to be noted that reducing the duty cycle on Li down to 30% brings the DDR ratio back to 0.073 and for 25%, it is 0.057.

It is therefore clear that within the limits imposed by the bipolar power supply (duty cycle can vary between 5 and 95%) that any $Li_xCoO_2$ composition with $1.00 \leq x \leq 1.10$ can be achieved.

It is understood that the present invention is by no means limited to the forms of the above detailed description and that many modifications can be made without departing from the scope of the appended claims.

For example, the present invention is also inclusive of a second (alternative) process for depositing a lithium cobalt oxide-based thin film on a substrate comprising the steps of:

- providing a substrate having a substrate surface;
- providing a first cobalt-based or lithium-based target;
- providing a second $Li_{y'}Co_zO_2$ target, wherein y' = z = 1.0;
- providing a first sputtering source comprising a first direct current (DC) power supply connected to a first sputtering cathode having a floating or grounded anode;
- providing a second sputtering source comprising a second unipolar pulsed direct current (P-DC) power supply connected to a second sputtering cathode having a floating or grounded anode;
- mounting said first cobalt-based or lithium-based target on said first sputtering cathode, so as to form a first magnetron;
- mounting said second $Li_{y'}Co_zO_2$ (with y' = z = 1.0) target on said second sputtering cathode, so as to form a second magnetron;
- placing said sputtering cathodes and said substrate in a vacuum chamber;
- supplying an oxygen-rich sputtering gas to said vacuum chamber;
- activating the first direct current (DC) power supply so as to generate a first plasma on the first cathode with a first power load (P1) and activating said second unipolar pulsed direct current (UP-DC) power supply so as to generate a second plasma on the second cathode with a second power load (P2) and choosing the power loads P1 and P2 in relation to a stoichiometry of the thin film $Li_xCo_yO_2$ wherein $0.50 \leq x/y \leq 1.10$, preferably with y = 1.00.

In the framework of the present invention, this second process is an alternative process to achieve the same technical effect relative to the first process of the invention - i.e. providing a process allowing a control of the Li:Co ratio of the lithium cobalt oxide-based thin film obtained by the (first or second) process according to the invention.

In this second process, the second sputtering magnetron(comprising the lithium cobalt oxide-based target) connected to a unipolar pulsed DC power supply is arranged to operate under frequencies of e.g. 40 kHz or 100 kHz; the duty cycle of this sputtering source is taken around 60%.

During operation, when the sputtering cathodes are mounted in the vacuum chamber and provided that the sputtering atmosphere is supplied in the vacuum chamber, the first and second power supplies are activated. The first sputtering cathode connected to a Co-based or a Li)-based target (which is an electrical conductor) can work under pulsed or continuous DC conditions whereas, for the second sputtering cathode, connected to a $LiCoO_2$-based target (which is a badly conducting material), it is preferable to work under pulsed DC conditions. Pulsed DC frequency for the second power source is of 40 kHz or of 100 kHz, but can be any value chosen in a range defined between 40 kHz and 250 kHz.

During deposition, the parameter x/y - also expressed as a Li:Co ratio - can be controlled by tuning the power magnitude of the first and second power supplies; allowing a controlled flux of Co or Li from the first target *versus* the flux from the $LiCoO_2$. The control of relative powers supplied to sputtering cathode 1 and 2 allows to explore the full range $50 \leq x/y \leq 1.10$ (preferably $0.60 \leq x/y \leq 0.80$ or $1.00 \leq x/y \leq 1.10$) of the $Li_xCo_yO_2$-based thin film cathode material claimed in the present invention.

The second process according to the present invention is furthermore covered by the hereunder provided preferred and non-limitative embodiments of the second process according to the present invention:

**Embodiment 1**

In a 1st embodiment of the second process of the invention, when the first magnetron comprises the Li-based first target, the power supplied to each of the first and second magnetrons is controlled so as to have a deposition of a $Li_xCoO_2$-based thin film wherein $1.00 \leq x \leq 1.10$, preferably x = 1.00.

**Embodiment 2**

In a 2nd embodiment of the second process according to the invention, when the first magnetron comprises the Co-based first target, the power supplied to each of the first and second magnetrons is controlled so as to have a deposition so as to have a deposition of a $Li_xCo_yO_2$-based thin film wherein $0.50 < x/y \leq 1.00$, preferably wherein $0.60 \leq x/y \leq 0.80$.

**Embodiment 3**

In a 3rd embodiment, a dual magnetron sputtering source is provided, said dual magnetron sputtering source comprising the first and the second cathodes.

**Embodiment 4**

Preferably, in a fourth embodiment, the first and second cathodes are individual single-cathodes, a first single-cathode being placed in a first bay or compartment of the vacuum chamber; a second single-cathode being placed in a second bay or compartment of the vacuum chamber.

More preferably, in **Embodiment 4**, the first and second parts of the vacuum chamber are two distinctive but adjacent deposition chambers. In case of **Embodiment 4** implemented on a dynamic coating line, the set of two adjacent deposition chambers can be repeated one or more times in order to make multilayers of alternatively either $Li/LiO_n$ or $Co/CoOm$ and $Li_xCoO_2$ which upon annealing at high temperatures (i.e. approximatively 600°C) yield the required stoichiometry for the cathode thin film. Also, in only one set of adjacent deposition chambers is provided, the substrate can be passed several times back-and-forth in front of these two deposition sources in order to reach the same effect of multilayers.

It is a specific advantage of Embodiment 4, the reactive gas atmospheres in the two adjacent deposition chambers can be individually chosen/tuned in order to better tune the overall oxygen-stoichiometry.

In the second process according to the invention, the first and second cathodes can be individual single-cathodes, a first single-cathode being placed in a first bay or coating chamber of the vacuum chamber; a second single-cathode being placed in a second bay or coating chamber of the vacuum chamber said coating chambers being adjacent to each other.

Possibly, the two adjacent coating chambers are repeated several times on a dynamic coating line in order to make multilayers consisting of thin layers of alternatively CoOm (with $m \geq 0$) or $LiO_n$ (with $n \geq 0$) and $LiCoO_2$.

Optionally, the substrate can be moved back and forth in front of the two coating chambers of a quasi-dynamic coating line several times in order to make multilayers consisting of thin layers of alternatively CoOm (with $m \geq 0$) or $LiO_n$ (with $n \geq 0$) and $LiCoO_2$.

Each of the individual second **Embodiments 1 to 4** described here-above may be combined with one or more of the second process embodiments described before it.

In view of the second process according to the present invention, the thin film lithium cobalt oxide-based cathode material according to the invention can be obtained by any of the processes claimed in any of claims 1 to 13. The first process is described by any of claims 1 to 4; whereas second process is covered by any of claims 5 to 11. For each of the two processes, planar or rotary targets can be used, as described in claims 12 and 13.

**Claims**

1. A process for depositing a lithium cobalt oxide-based thin film on a substrate comprising the steps of:

- providing a substrate having a substrate surface;
- providing a first LiCoO$_2$ (or lithium cobalt oxide-based) target;
- mounting said first LiCoO$_2$ (or lithium cobalt oxide-based) target on a first sputtering cathode of a sputtering source so as to form a first magnetron of the sputtering source;
- placing the first sputtering cathode and the substrate into a vacuum chamber;
- supplying an inert sputtering gas comprising with oxygen, preferably at least 25 vol.%, to said vacuum chamber; and
- activating said sputtering source with an electric power supply so as to deposit on the substrate surface a lithium cobalt oxide thin film ,

**characterized in that** it comprises the further steps of:

- providing as the sputtering source a dual magnetron sputtering source comprising a bipolar pulsed direct current (BP-DC) power supply connected to the first sputtering cathode and to a second sputtering cathode
- providing a second Co-based or Li-based material target;
- mounting said second Co-based or Li-based target on said second sputtering cathode, so as to form a second magnetron of the dual magnetron sputtering source;
- placing said second sputtering cathode in the vacuum chamber;

**and in that** the step of activating said sputtering source consists in activating the bipolar pulsed direct current (BP-DC) power supply for alternatively applying on each of the first and second magnetrons a nominal electrical power P$_{nom}$ of a predetermined value so as to alternatively deposit on the substrate surface the lithium cobalt oxide from the first sputtering cathode and the lithium or the cobalt material from the second sputtering cathode, during said step of activating, duty cycles (d$_1$, d$_2$) during which the nominal electrical power P$_{nom}$ are respectively applied on each of the two cathodes (1,2) are controlled so as to reach a thin film composition having a formula Li$_x$CO$_y$O$_2$ presenting a controlled molar ratio Li:Co with x/y being comprised between 0.50 and 1.10.

2. The process of claim 1, **characterized in that**, the step of activating said bipolar pulsed DC power supply is performed so as to alternatively apply the nominal power P$_{nom}$ at a frequency 1/T chosen so as to minimize the arcing during said sputtering process.

3. The process of claim 1 or 2, **characterized in that**, the step of activating said sputtering source is performed under a power-control mode.

4. The process of any of claims 1 to 3, **characterized in that** $0.50 \leq x/y \leq 1.10$.

5. A process for depositing a lithium cobalt oxide-based thin film on a substrate comprising the steps of:

- providing a substrate having a substrate surface;
- providing a first cobalt-based or lithium-based target ;
- providing a second Li$_{y'}$Co$_z$O$_2$ target, wherein y' = z = 1.0;
- providing a first sputtering source comprising a first direct current (DC) power supply connected to a first sputtering cathode having a floating or grounded anode;
- providing a second sputtering source comprising a second unipolar pulsed direct current (UP-DC) power supply connected to a second sputtering cathode having a floating or grounded anode;
- mounting said first cobalt-based or lithium-based target on said first sputtering cathode, so as to form a first magnetron;
- mounting said second Li$_{y'}$Co$_z$O$_2$ (with y' = z = 1.0) target on said second sputtering cathode, so as to form a second magnetron;
- placing said sputtering cathodes and said substrate in a vacuum chamber;
- supplying an inert sputtering gas containing oxygen, preferably at a content of at least 25 vol.%, to said vacuum chamber;
- activating the first direct current (DC) power supply so as to generate a first plasma on the first cathode with a first power load (P1) and activating said second unipolar pulsed direct current (UP-DC) power supply so as to generate a second plasma on the second cathode with a second power load (P2) and choosing the power loads P1 and P2 in relation to a stoichiometry of the thin film Li$_x$CoyO$_2$ wherein $0.50 \leq x/y \leq 1.10$, preferably with y = 1.00.

6. The process according to claim 5, wherein a dual magnetron sputtering source is provided, said dual magnetron sputtering source comprising the first and the second cathodes.

7. The process according to claim 5, wherein the first and second cathodes are individual single-cathodes, a first single-cathode being placed in a first bay or coating chamber of the vacuum chamber; a second single-cathode being placed in a second bay or coating chamber of the vacuum chamber said coating chambers being adjacent to each other.

8. The process according to claim 7, wherein the two adjacent coating chambers are repeated several times on a dynamic coating line in order to make multilayers consisting of thin layers of alternatively CoOm (with m $\geq$ 0) or LiO$_n$ (with n $\geq$ 0) and LiCoO$_2$.

9. The process according to claim 7, wherein the substrate is moved back and forth in front of the two coating chambers of a quasi-dynamic coating line several times in order to make multilayers consisting of thin layers of alternatively CoOm (with m $\geq$ 0) or LiO$_n$ (with n $\geq$ 0) and LiCoO$_2$.

10. The process according to any of claims 5 to 9 wherein, when the first magnetron comprises the Li-based first target, the power supplied to each of the first and second magnetrons is controlled so as to have a deposition of a Li$_x$CoO$_2$-based thin film wherein 1.00 $\leq$ x $\leq$ 1.10, preferably x = 1.00.

11. The process according to any of claims 5 to 9 wherein, when the first magnetron comprises the Co-based first target, the power supplied to each of the first and second magnetrons is controlled so as to have a deposition so as to have a deposition of a Li$_x$Co$_y$O$_2$-based thin film wherein 0.50 < x/y $\leq$ 1.00, preferably wherein 0.60 $\leq$ x/y $\leq$ 0.80.

12. The process according to any of the claims 1 to 4 or 5 to 11 **characterized in that** the sputtering cathodes are planar cathodes.

13. The process according to any of the claims 1 to 4 or 5 to 11 **characterized in that** the sputtering cathodes are cylindrical rotary cathodes.

Insulating Material

Metallized Flex Circuit Encapsulation     −

Insulating Material     vias

Li Metal Anode

$LiCoO_2$ Cathode

LiPON Electrolyte

Metal Foil Substrate (cathode current collector)     +

170μm

*Fig.1*

*Fig.2*

Europäisches
Patentamt

European
Patent Office

Office européen
des brevets

## EUROPEAN SEARCH REPORT

Application Number

EP 17 16 8949

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2008/213664 A1 (KRASNOV VICTOR [US] ET AL) 4 September 2008 (2008-09-04) * abstract; figures 7A,7B,7C * * paragraphs [0001], [0002], [0026], [0039], [0041], [0044] - [0047], [0051] * | 1,3,5,12 | INV. H01J37/34 H01J37/32 C23C14/35 C23C14/34 C23C14/54 C23C14/56 C23C14/08 |
| | ----- | | |
| A | US 2016/233541 A1 (ANAPOLSKY ABRAHAM [US] ET AL) 11 August 2016 (2016-08-11) * abstract; figure 4 * * paragraphs [0001], [0017], [0018], [0040] - [0053] * | 1,3,5,6,13 | |
| | ----- | | |
| A | US 2013/164459 A1 (NIEH KAI WEI [US] ET AL) 27 June 2013 (2013-06-27) * abstract; figures 4A,4B,5A * * paragraphs [0001] - [0003], [0024], [0025], [0030] - [0032], [0039], [0044] - [0050], [0056] - [0058], [0063] * | 1,3,5,12,13 | |
| | ----- | | |
| A | HWANG MAN-SOO ET AL: "Properties of Co-deposited indium tin oxide and zinc oxide films using a bipolar pulse power supply and a dual magnetron sputter source", JOURNAL OF VACUUM SCIENCE AND TECHNOLOGY: PART A, AVS /AIP, MELVILLE, NY., US, vol. 21, no. 4, 1 July 2003 (2003-07-01), pages 1399-1403, XP012006447, ISSN: 0734-2101, DOI: 10.1116/1.1575225 * abstract; figures 1,2 * * the whole document * | 1-3,5,6,12 | **TECHNICAL FIELDS SEARCHED (IPC)** H01J C23C H01M |
| | ----- | | |
| | -/-- | | |

The present search report has been drawn up for all claims

| Place of search | Date of completion of the search | Examiner |
|---|---|---|
| The Hague | 23 October 2017 | Remy, Jérôme |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2011/143331 A1 (ADVANCED ENERGY IND INC [US]; NAUMAN KENNETH E [US]; FINLEY KENNETH [U]) 17 November 2011 (2011-11-17) * abstract; figures 1,2,4,5,7 * * paragraphs [0001], [0010], [0012] - [0022], [0026] - [0029], [0041], [0046], [0049], [0050], [0059] - [0066], [0075] * ----- | 1-3,5,6, 13 | |

TECHNICAL FIELDS
SEARCHED    (IPC)

The present search report has been drawn up for all claims

| Place of search | Date of completion of the search | Examiner |
|---|---|---|
| The Hague | 23 October 2017 | Remy, Jérôme |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
........................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 17 16 8949

This annex lists the patent family members relating to the patent documents cited in the above-mentioned European search report.
The members are as contained in the European Patent Office EDP file on
The European Patent Office is in no way liable for these particulars which are merely given for the purpose of information.

23-10-2017

| Patent document cited in search report | Publication date | Patent family member(s) | | Publication date |
|---|---|---|---|---|
| US 2008213664 A1 | 04-09-2008 | KR 20080080900 A<br>US 2008213664 A1<br>WO 2008108999 A2 | | 05-09-2008<br>04-09-2008<br>12-09-2008 |
| US 2016233541 A1 | 11-08-2016 | NONE | | |
| US 2013164459 A1 | 27-06-2013 | US 2013164459 A1<br>WO 2013095787 A1 | | 27-06-2013<br>27-06-2013 |
| WO 2011143331 A1 | 17-11-2011 | CN 102985996 A<br>EP 2569798 A1<br>KR 20130121682 A<br>US 2011248633 A1<br>WO 2011143331 A1 | | 20-03-2013<br>20-03-2013<br>06-11-2013<br>13-10-2011<br>17-11-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20150248997 A
- US 5171413 A

### Non-patent literature cited in the description

- *Adv. Mat. Lett.,* 2013, vol. 4 (8), 615-620
- Electrochemical Energy Storage and Conversion. **YUPING WU.** Lithium-Ion Batteries: Fundamentals and Applications. CRC Press, 2015, vol. 4
- **XIA, H. ; MENG, SHIRLEY Y. ; LU, LI ; CEDER, GERBRAND (CEDER et al.** Electrochemical Behavior and Li Diffusion Study of LiCoO2 Thin Film Electrodes Prepared by PLD. *DSpace@MIT, http://hdl.handle.net/1721.1/35827*
- *Journal of Applied Physics,* 05 April 2014, vol. 115 (15), 154906-154906